# EUROPEAN PATENT SPECIFICATION

(11) **EP 1 469 604 B1**
(45) Date of publication and mention of the grant of the patent: **12.08.2009**
(21) Application number: 02786127.7
(22) Date of filing: 17.12.2002
(51) Int. Cl.: H03K 21/00, H03K 23/64, H03K 23/66

(54) **TWO-MODULUS PRESCALER CIRCUIT**
MODULUS-ZWEI-VORSKALIERERSCHALTUNG
CIRCUIT GENERATEUR D'ECHELLES A DEUX MODULES

(30) Priority: 20.12.2001 JP 2001386873
(43) Date of publication of application: 20.10.2004
(73) Proprietor: NIPPON TELEGRAPH AND TELEPHONE CORPORATION, Tokyo 100-8116 (JP); NTT ELECTRONICS CORPORATION, Shibuya-ku, Tokyo 150-0043 (JP)
(72) Inventor: YAMAGISHI, Akihiro, NTT Intellectual Prop. Center, Musashino-shi, Tokyo 180-8585 (JP); TSUKAHARA, Tsuneo, NTT Intellectual Prop. Center, Musashino-shi, Tokyo 180-8585 (JP); SHIMPO, Yukio, NTT ELECTRONICS CORPORATION, Shibuya-ku, Tokyo 150-0043 (JP)
(74) Representative: HOFFMANN EITLE
(86) International application number: PCT/JP2002/013190
(87) International publication number: WO 2003/058817

(56) References cited:
- JP-A- 08 204 541
- JP-A- 2000 049 590
- JP-A- 2001 186 012
- US-A- 4 695 743
- US-A- 5 818 293
- US-B1- 6 265 898
- YANG C-Y ET AL: "FAST-SWITCHING FREQUENCY SYNTHESIZER WITH A DISCRIMINATOR-AIDED PHASE DETECTOR" IEEE JOURNAL OF SOLID-STATE CIRCUITS, IEEE INC. NEW YORK, US, vol. 35, no. 10, October 2000 (2000-10), pages 1445-1452, XP001143289 ISSN: 0018-9200

## Description

### Technical Field

The present invention relates to a dual modulus prescaler circuit applicable to frequency synthesizers and the like. Specifically, the present invention relates to a dual modulus prescaler circuit which can operate with small signal amplitude and with reduced power consumption.

### Background of the Invention

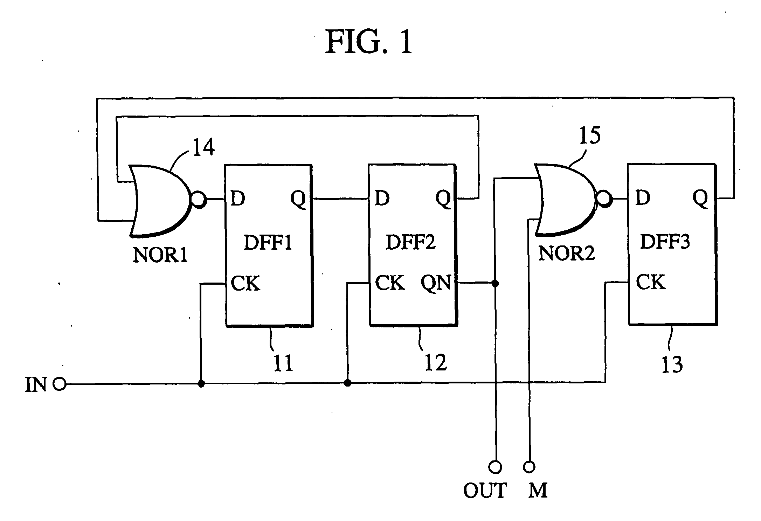

A "divide-by 4/divide-by 5 divider" switchable between divide-by 4 and divide-by 5 modes, which is a basis for a dual modulus prescaler used for a pulse swallow type PLL synthesizer, is composed of a circuit as shown in FIG. 1. In FIG. 1, reference numerals 11 to 13 denote D flip-flop circuits (DFF circuits), and reference numerals 14 and 15 denote NOR circuits. This circuit is configured to switch between divide-by 4 and divide-by 5 modes by means of a polarity of an input signal of a terminal M.

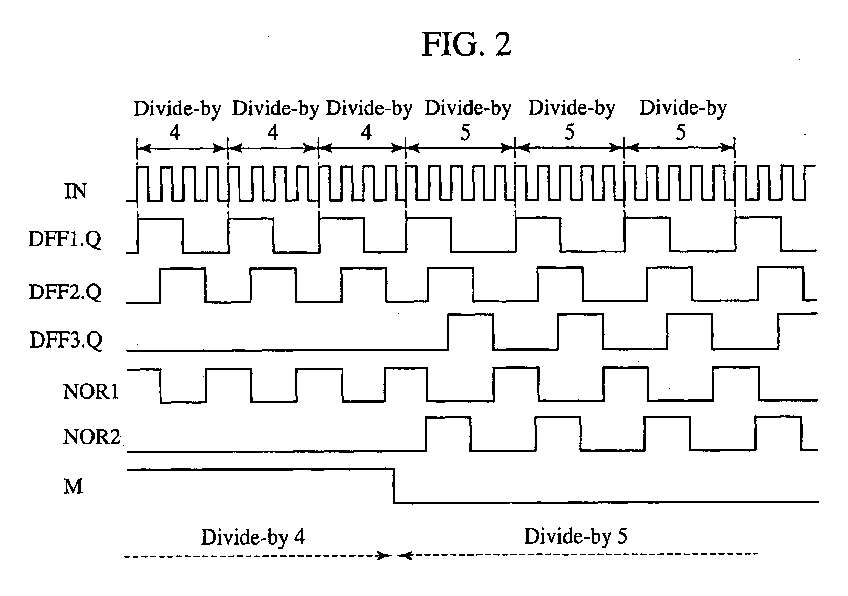

FIG. 2 is a timing chart showing an operation of the "divide-by 4/divide-by 5 divider". As shown in FIG. 2, in the "divide-by 4/divide-by 5 divider", when an input of the terminal M is Hi, an input D of the DFF3 remains unchanged, and the input signal is frequency-divided by four with the DFF1 and DFF2. On the contrary, when the input of the terminal M is Low, the DFF3 operates, and the input signal is frequency-divided by five.

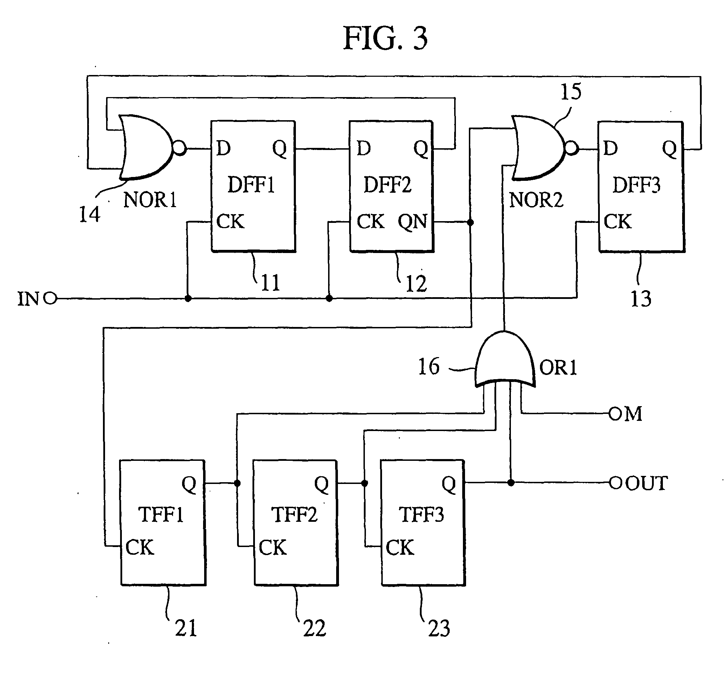

Further, by adding a frequency divider to the output of the circuit, a dual modulus prescaler circuit switchable between divide-by 2n and divide-by 2n+1 modes can be configured. FIG. 3 is a block diagram of a "divide-by 32/divide-by 33 divider" using the "divide-by 4/divide-by 5 divider". Reference numerals 11 to 13 denote D flip-flop circuits (DFF circuits); 14 and 15, NOR circuits; 16, an OR circuit; and 21 to 23, T flip-flop circuits (TFF circuits).

In the circuit of FIG. 3, each of the DFF1, DFF2, and DFF3 constituting the "divide-by 4/divide-by 5 divider" is required to operate at a frequency of an input signal. The TFF1, TFF2, and TFF3 which receive divided signals operate at a lower frequency as they get closer to the last stage .

Therefore, in order to reduce the power consumption of the dual modulus prescaler, it is important to reduce the power consumption of the "divide-by 4/divide-by 5 divider". Generally, prescalers require high-speed operation, and so bipolar processes are often used. However, CMOS prescalers have been developed along with achieving higher speed CMOS processes in recent years.

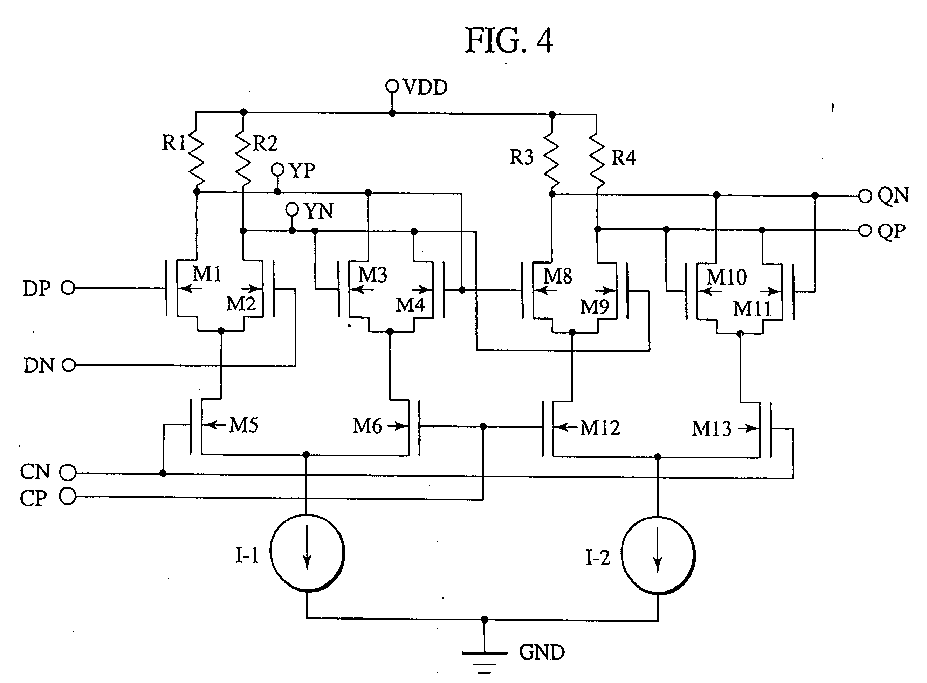

In the case of CMOS processes, it is possible to conceive a DFF circuit using a current mode logic circuit as shown in FIG. 4, which can be expected to offer faster performance than that using normal CMOS gates. The circuit of FIG. 4 includes a master FF and a slave FF. The master FF is composed of transistors M1 to M6 and R1 and R2, and the slave FF is composed of M8 to M13, R3, and R4. I-1 and I-2 of FIG. 4 denote current sources.

The transistors M5 and M6 and the transistors M12 and M13 are turned on and off by a clock inputted as a differential signal to switch current paths. When CN is Hi and CP is Low, the current path is through the M5 side in the master FF. At this time, if a gate voltage IN of M1 is higher than a gate voltage IP of M2, current flows through R1 , and Low is read. If IN is lower than IP, current flows through R2, and Hi is read. Simultaneously, the current path is through the M13 side in the slave FF, and an output is held by M10 and M11.

When CN is Low and CP is Hi, the current path is through the M6 side in the master FF, and data is held by M3 and M4. The current path is through the M12 side in the slave FF, and data is outputted through M8 and M9. This circuit operates as a DFF circuit according to the aforementioned operations.

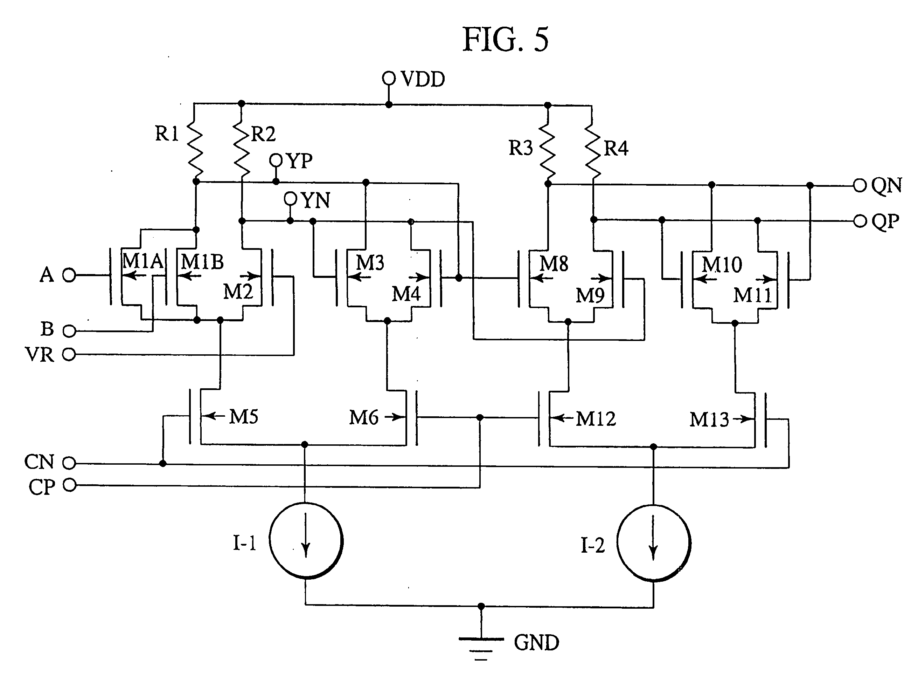

The NOR circuit used in the "divide-by 4/divide-by 5 divider" can be easily implemented only by replacing the transistor M1 for data input in the DFF circuit of FIG. 4 with transistors M1A and M1B connected to each other in parallel as shown in FIG. 5. Signals and the like in FIG. 5 are the same as those in FIG. 4.

In the DFF circuit with a NOR gate shown in FIG. 5, in reading data when CP is Low, if any one of a gate voltage A of M1A and a gate voltage B of M1B or both thereof are higher than a gate voltage VR of M2, current flows through R1, and Low is read. When both of A and B are lower than VR, current flows through R2, and Hi is read. Therefore, this circuit operates as a DFF circuit with a NOR gate.

The DFF circuit with a NOR gate shown in FIG. 5 requires a threshold voltage VR for judging whether data is Low or Hi since single-phase data is inputted. Power supply voltage necessary for operating this circuit requires being a voltage value obtained by adding signal amplitude to operating voltages of individual transistors. The DFF circuit with a NOR gate of FIG. 5 requires a total voltage of a voltage for operating three transistors and signal amplitude.

Larger signal amplitude provides larger operating margins but requires larger power supply voltage. The DFF circuit with a NOR gate of FIG. 5 requires larger signal amplitude to ensure a DC bias operating margin since single-phase data is inputted. Therefore, it is difficult to reduce the power supply voltage.

US5818293 and the paper "Fast-Switching Frequency Synthesizer with a Discriminator-Aided Phase Detector', by Yang and Liu, IEEE Journal of Solid-State circuits, vol. 35, no.10, Oct. 2000, teach various prescalers.

### Summary of the Invention

The present invention according to the application was made to solve the aforementioned problem. Specifically, an aspect of the present invention according to claim 1 is a dual modulus prescaler circuit for dividing an inputted clock signal (INP, INN) to obtain a divide ratio which is selected by a switching signal (MP,MN) from a combination of predetermined divide ratios, the dual modulus prescaler circuit comprising:
n D flip-flop circuits (DFF1-3), n being a natural number not less than three;
a first multi-input logic gate circuit (NOR1) including at least two inputs; and
a second multi-input logic gate circuit (NOR2) including at least two inputs, wherein:
   data input terminals (DP,DN) of the first D flip-flop circuit (DFF1) are connected to output terminals of the first multi-input logic circuit (NOR1);
   output terminals (QP,QN) of the first to n-2th D flip-flop circuits (DFF1) are connected to data input terminals (DP,DN) of the second to n-1th D flip-flop circuits (DFF2), respectively,
   input terminals of the first multi-input logic gate circuit (NOR1) are connected to output terminals (QP,QN) of the n-1th D flip-flop circuit (DFF2) and to output terminals (QP,QN) of nth flip-flop circuit (DFF3);
   input terminals of the second multi-input logic gate circuit (NOR2) are connected to output terminals (QP,QN) of the n-1th D flip-flop circuit (DFF2) and the switching signal (MP,MN), which is differential, is inputted to other input terminals of the second multi-input logic gate circuit (NOR2);
   a data input terminal (DP,DN) of the nth D flip-flop circuit (DFF3) is connected to an output terminal of the second multi-input logic gate circuit (NOR2);
   all the connections are connections using differential signals;
   each of the first multi-input logic gate circuit (NOR1) and the second multi-input logic gate circuit (NOR2) includes:
      first and second resistors (R1,R2) each of which has an end connected to a power supply (VDD);
      m first transistors (M1,M2) in which a source and a drain are connected between an output end of a current source (I-1) and the other end of the first resistor (R1) in parallel, m being a natural number not less than two;
      m second transistors (M3, M4) whose sources and drains are connected between the output end of the current source (I-1) and the other end of the second resistor (R2) in series;
   m differential input data (AP, AN/BP, BN) are inputted to each of the gates of the first transistors (M1,M2) connected in parallel and the gates of the second transistors (M3, M4) connected in series; and
   a differential signal (YP, YN) is outputted from the other ends of the each of the first and second resistors (R1, R2).

Another aspect of the present invention according to claim 2 is a dual modulus prescaler circuit for dividing an inputted clock signal (INP, INN) to obtain a divide ratio which is selected by a switching signal (MP,MN) from a combination of predetermined divide ratios, the dual modulus prescaler circuit comprising:
n D flip-flop circuits (DFF1-3), n being a natural number not less than three;
a first multi-input logic gate circuit (NOR1) including at least two inputs and forming part of the first D flip-flop circuit (DFF1);
a second multi-input logic gate circuit (NOR2) including at least two inputs and forming part of the nth D flip-flop circuit (DFF3), wherein:
   internal nodes (DP,DN) of the first D flip-flop circuit (DFF1) are connected to output terminals of the first multi-input logic circuit (NOR1);
   output terminals (QP,QN) of the first to n-2th D flip-flop circuits (DFF1) are connected to data input terminals (DP,DN) of the second to n-1th D flip-flop circuits (DFF2), respectively,
   input terminals of the first multi-input logic gate circuit (NOR1) are connected to output terminals (QP,QN) of the n-1th D flip-flop circuit (DFF2) and to output terminals (QP,QN) of nth flip-flop circuit (DFF3);
   input terminals of the second multi-input logic gate circuit (NOR2) are connected to output terminals (QP,QN) of the n-1th D flip-flop circuit (DFF2), and the switching signal (MP,MN), which is differential, is inputted to other input terminals of the second multi-input logic gate circuit (NOR2);
   internal nodes (DP,DN) of the nth D flip-flop circuit (DFF3) are connected to output nodes of the second multi-input logic gate circuit (NOR2);
   all the connections are connections using differential signals;
   wherein each of the first D flip-flop circuit (DFF1) and the nth D flip-flop circuit (DFF3) includes:
      m first transistors (M1A, M1B);
      m second transistors (M2A, M2B);
      first and second resistors (R1, R2), each having one end connected to a power supply (Vcc);
      third and fourth transistors (M5,M6) whose sources are connected to an output end of a first current source (I-1), or to ground;
      fifth and sixth transistors (M12, M13) whose sources are connected to a drain of a second current source (I-2) 4 or to ground;
      seventh and eighth transistors (M3, M4) whose sources are connected to a drain of the fourth transistor (M6);
      ninth and tenth transistors (M8,M9) whose sources are connected to a drain of the fifth transistor (M12);
      eleventh and twelfth transistors (M10,M11) whose sources are connected to a drain of the sixth transistor (M13);
      third and fourth resistors (R3, R4) each of which has one of the terminals connected to the power supply (VDD), wherein:
   drains of the ninth and the eleventh transistors (M8, M10) are connected to the other terminal of the third resistor (R3);
   drains of the tenth and the twelfth transistors (M9, M11) are connected to the other terminal of the fourth resistor (R4);
   the sources and the drains of the m first transistors ( M1A, M1B) are coupled in parallel between the third transistor (M5) and the other output terminal of the first resistor (R1);
   the sources and the drains of the m second transistors ( M2A, M2B) are coupled in series between the third transistor (M5) and the other output terminal of the second resistor (R2);
   a differential clock signal (CN, CP) is inputted to the gates of the third and sixth transistors (M5, M13) and to the gates of the fourth and fifth transistors (M6, M12);
   a differential signal (YN, YP) at said internal nodes, formed of the other ends of the first and second resistors (R1, R2), is inputted to the gates of the seventh and tenth transistors (M3, M9) and to the gates of the eight and ninth transistors (M4, M8) and
   to the drains of the seventh and eighth transistors (M3, M4); and
   the differential output signal (QN, QP) of the D flip-flop circuit is outputted from the other ends of the each of the third and fourth resistors (R3, R4).

### Brief Description of the Drawings

FIG. 1 is a view showing a configuration of a conventional "divide-by 4/divide-by 5 divider".
FIG. 2 is a view showing a timing chart of the conventional "divide-by 4/divide-by 5 divider".
FIG. 3 is a view showing a configuration of a conventional "divide-by 32/divide-by 33 divider".
FIG. 4 is a view showing a configuration of a conventional DFF circuit.
FIG. 5 is a view showing a configuration of a conventional DFF circuit with a NOR gate.
FIG. 6 is a view showing a configuration of a circuit according to a first embodiment.
FIG. 7 is a view showing a configuration of a differential input/output NOR circuit according to the first embodiment.
FIG. 8 is a view showing a configuration of a DFF circuit with a NOR gate according to a second embodiment.

### Detail Description of the Invention

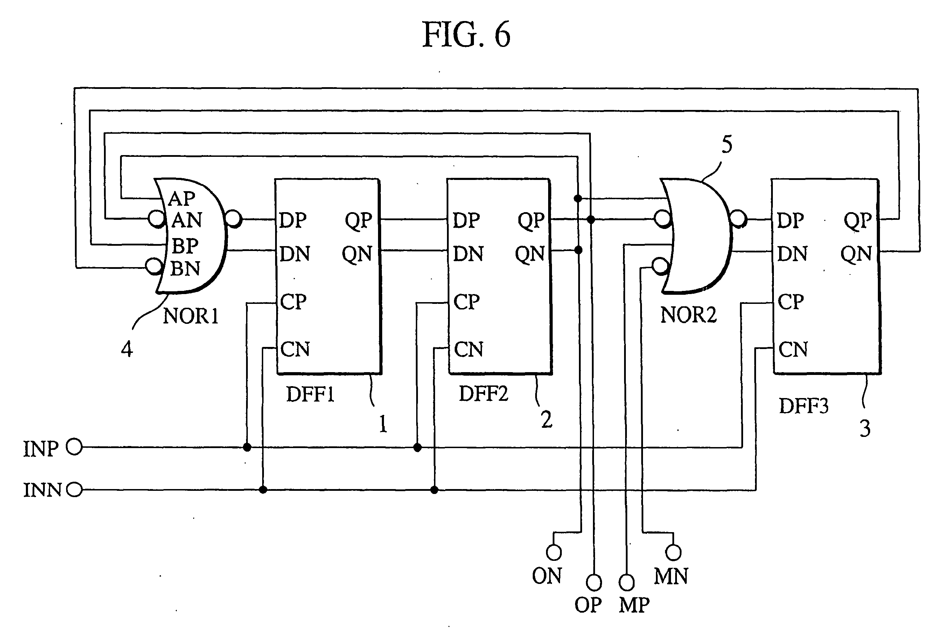

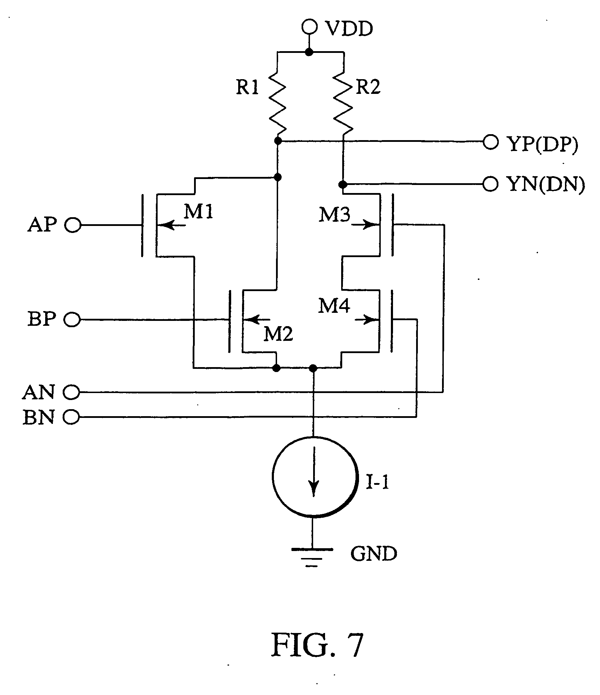

FIG. 6 is a view showing a first embodiment of the present invention. This embodiment corresponds to an aspect of the present invention according to claim 1. In the drawing, reference numerals 1 to 3 denote DFF circuits, and 4 and 5 denote NOR circuits. The circuit of FIG. 6 is configured so that differential signals are inputted to/outputted from all the DFF circuits (D flip-flop circuits) and NOR circuits (multi-input logical gate circuits). The differential input/output NOR circuit shown in FIG. 7 corresponds to the NOR circuit defined by the present invention according to claim 1.

The circuit of FIG. 7 is a NOR circuit operated in a current mode in order to ensure high speed performance. In FIG. 7, R1 and R2 denote resistors; M1 to M4, transistors; I-1, a current source; AP, an input signal; and YP, an output signal. When the terminals AP and BP in the circuit of FIG. 7 are Hi, AN and BN are Low. At this time, current flows through R1 but does not flow through R2. Accordingly, YP is Low, and YN is Hi. When AP is Hi and BP is Low or when AP is Low and BP is Hi, current flows through R1. Accordingly, YP is Low, and YN is Hi. In other words, YP acts as the NOR to AP and BP. Herein, the aforementioned circuit of FIG. 4 is used for each of the DFF circuits.

The circuit of FIG. 4 includes a master FF and a slave FF. The master FF is composed of transistors M1 to M6 and R1 and R2, and the slave FF is composed of M8 to M13 and R3 and R4. The transistors M5 and M6 and the transistors M12 and M13 are turned on and off by a clock inputted as a differential signal to switch current paths.

When CN is Hi and CP is Low, the current path is through the M5 side in the master FF. At this time, if a gate voltage IN of M1 is higher than a gate voltage IP of M2, current flows through R1, and Low is read. If IN is lower than IP, current flows through R2, and Hi is read. Simultaneously, the current path in the slave FF is through the M13 side, and the output is held by M10 and M11.

When CN is Low and CP is Hi, the current path is through the M6 side in the master FF, and data is held by M3 and M4. In the slave FF, the current path is through the M12 side, and data is outputted through M8 and M9. This circuit operates as a DFF circuit according to the aforementioned operations. A fully differential "divide-by 4/divide-by 5 divider" can be implemented by using the circuit of FIG. 7 for each NOR circuit and using the circuit of FIG. 4 for each DFF circuit.

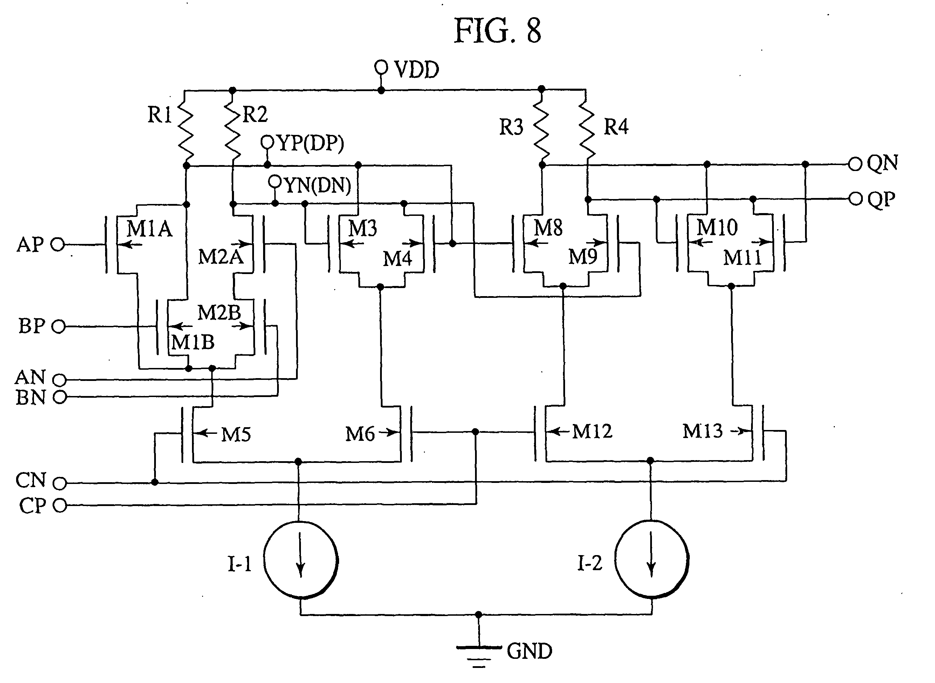

FIG. 8 is a view showing a second embodiment of the present invention, corresponding to still another aspect of the invention according to claim 2. The circuit of FIG. 8 is a circuit in which the transistor M2 of the DFF circuit with a NOR gate shown in FIG. 5 is replaced with transistors M2A and M2B which are connected in series. In the circuit of FIG. 8, differential signals are applied between AP and AN and between BP and BN.

In reading data when CP is Low, only in the case where AP and BP are Low, AN and BN are Hi, and current flows through R2. Accordingly, Hi is read. In other cases, current flows through any one or both of M1A and M1B, and any one or both of M2A and M2B are turned off. Accordingly, current flows through R1, and Low is read.

Therefore, the circuit of FIG. 8 operates as the DFF circuit with a NOR gate. It is possible to implement the fully differential "divide-by 4/divide-by 5 divider" by applying the DFF circuit with a NOR gate of FIG. 8 to each of combinations of NOR1 and DFF1 and of NOR2 and DFF 3 in FIG. 6 and applying the DFF circuit of FIG. 4 to DFF2. Moreover, the DFF circuit with a NOR gate of FIG. 8 and the DFF circuit of FIG. 4 can operate even when the current sources are omitted since the clock signals thereof are differential. Accordingly, the power supply voltage can be further lowered by omitting the current sources.

### Industrial Applicability

According to the present invention, all the circuits constituting the dual modulus prescaler are designed to be differential input and/or differential output circuits. Accordingly, compared to conventional circuits, operating margins for signal amplitude and a signal direct current level can be increased, so that the dual modulus prescaler can operate with smaller signal amplitude. This offers advantages of reducing power supply voltage and power consumption.

## Claims

1. A dual modulus prescaler circuit for dividing an inputted clock signal (INP, INN) to obtain a divide ratio which is selected by a switching signal (MP,MN) from a combination of predetermined divide ratios, the dual modulus prescaler circuit comprising:
n D flip-flop circuits (DFF1-3), n being a natural number not less than three;
a first multi-input logic gate circuit (NOR1) including at least two inputs; and
a second multi-input logic gate circuit (NOR2) including at least two inputs, wherein:
data input terminals (DP,DN) of the first D flip-flop circuit (DFF1) are connected to output terminals of the first multi-input logic circuit (NOR1);
output terminals (QP,QN) of the first to n-2th D flip-flop circuits (DFF1) are connected to data input terminals (DP,DN) of the second to n-1th D flip-flop circuits (DFF2), respectively,
input terminals of the first multi-input logic gate circuit (NOR1) are connected to output terminals (QP,QN) of the n-1th D flip-flop circuit (DFF2) and to output terminals (QP,QN) of nth flip-flop circuit (DFF3);
input terminals of the second multi-input logic gate circuit (NOR2) are connected to output terminals (QP,QN) of the n-1th D flip-flop circuit (DFF2) and the switching signal (MP,MN), which is differential, is inputted to other input terminals of the second multi-input logic gate circuit (NOR2);
a data input terminal (DP,DN) of the nth D flip-flop circuit (DFF3) is connected to an output terminal of the second multi-input logic gate circuit (NOR2);
all the connections are connections using differential signals;
each of the first multi-input logic gate circuit (NOR1) and the second multi-input logic gate circuit (NOR2) includes:
first and second resistors (R1,R2) each of which has an end connected to a power supply (VDD);
m first transistors (M1,M2) in which a source and a drain are connected between an output end of a current source (I-1) and the other end of the first resistor (R1) in parallel, m being a natural number not less than two;
m second transistors (M3, M4) whose sources and drains are connected between the output end of the current source (I-1) and the other end of the second resistor (R2) in series;
m differential input data (AP, AN/BP, BN) are inputted to each of the gates of the first transistors (M1,M2) connected in parallel and the gates of the second transistors (M3, M4) connected in series; and
a differential signal (YP, YN) is outputted from the other ends of the each of the first and second resistors (R1, R2).

2. A dual modulus prescaler circuit for dividing an inputted clock signal (INP, INN) to obtain a divide ratio which is selected by a switching signal (MP,MN) from a combination of predetermined divide ratios, the dual modulus prescaler circuit comprising:
n D flip-flop circuits (DFF1-3), n being a natural number not less than three;
a first multi-input logic gate circuit (NOR1) including at least two inputs and forming part of the first D flip-flop circuit (DFF1);
a second multi-input logic gate circuit (NOR2) including at least two inputs and forming part of the nth D flip-flop circuit (DFF3), wherein:
internal nodes (DP,DN) of the first D flip-flop circuit (DFF1) are connected to output terminals of the first multi-input logic circuit (NOR1);
output terminals (QP,QN) of the first to n-2th D flip-flop circuits (DFF1) are connected to data input terminals (DP,DN) of the second to n-1th D flip-flop circuits (DFF2), respectively,
input terminals of the first multi-input logic gate circuit (NOR1) are connected to output terminals (QP,QN) of the n-1th D flip-flop circuit (DFF2) and to output terminals (QP,QN) of nth flip-flop circuit (DFF3);
input terminals of the second multi-input logic gate circuit (NOR2) are connected to output terminals (QP,QN) of the n-1th D flip-flop circuit (DFF2), and the switching signal (MP,MN), which is differential, is inputted to other input terminals of the second multi-input logic gate circuit (NOR2);
internal nodes (DP,DN) of the nth D flip-flop circuit (DFF3) are connected to output nodes of the second multi-input logic gate circuit (NOR2);
all the connections are connections using differential signals;
wherein each of the first D flip-flop circuit (DFF1) and the nth D flip-flop circuit (DFF3) includes:
in first transistors (M1A, M1B);
m second transistors (M2A, M2B);
first and second resistors (R1, R2), each having one end connected to a power supply (Vcc);
third and fourth transistors (M5,M6) whose sources are connected to an output end of a first current source (I-1), or to ground;
fifth and sixth transistors (M12, M13) whose sources are connected to a drain of a second current source (I-2) 4 or to ground;
seventh and eighth transistors (M3, M4) whose sources are connected to a drain of the fourth transistor (M6);
ninth and tenth transistors (M8,M9) whose sources are connected to a drain of the fifth transistor (M12);
eleventh and twelfth transistors (M10,M11) whose sources are connected to a drain of the sixth transistor (M13);
third and fourth resistors (R3, R4) each of which has one of the terminals connected to the power supply (VDD), wherein:
drains of the ninth and the eleventh transistors (M8, M10) are connected to the other terminal of the third resistor (R3);
drains of the tenth and the twelfth transistors (M9, M11) are connected to the other terminal of the fourth resistor (R4);
the sources and the drains of the m first transistors ( M1A, M1B) are coupled in parallel between the third transistor (M5) and the other output terminal of the first resistor (R1);
the sources and the drains of the m second transistors ( M2A, M2B) are coupled in series between the third transistor (M5) and the other output terminal of the second resistor (R2);
a differential clock signal (CN, CP) is inputted to the gates of the third and sixth transistors (M5, M13) and the gates of the fourth and fifth transistors (M6, M12);
a differential signal (YN, YP) at said internal nodes, formed of the other ends of the first and second resistors (R1, R2), is inputted to the gates of the seventh and tenth transistors (M3, M9) and to the gates of the eight and ninth transistors (M4, M8) and
to the drains of the seventh and eighth transistors (M3, M4); and
the differential output signal (QN, QP) of the D flip-flop circuit is outputted from the other ends of the each of the third and fourth resistors (R3, R4).

3. The dual modulus prescaler circuit according to claim 2, wherein
the sources of the third, fourth, fifth an sixth transistors (M5, M6, M12, M13) are connected to ground.

## Patentansprüche

1. Dualmodul-Vorteilerschaltung zum Teilen eines eingegebenen Eingangssignals (INP, INN), um ein Teilungsverhältnis, das durch ein Schaltsignal (MP, MN) ausgewählt ist, aus einer Kombination vorbestimmter Teilungsverhältnisse zu erhalten, wobei die Dualmodul-Vorteilerschaltung umfasst:
n D-Flip-Flop-Schaltungen (DFF1-3), wobei n eine natürliche Zahl nicht geringer als drei ist;
eine erste Mehrfacheingang-Logikgatterschaltung (NOR1), die zumindest zwei Eingänge einschließt; und
eine zweite Mehrfacheingang-Logikgatterschaltung (NOR2), die zumindest zwei Eingänge einschließt, wobei:
Dateneingangsanschlüsse (DP, DN) der ersten D-Flip-Flop-Schaltung (DFF1) mit Ausgangsanschlüssen der ersten Mehrfacheingang-Logikschaltung (NOR1) verbunden sind;
Ausgangsanschlüsse (QP, QN) der ersten bis n-2-ten D-Flip-Flop-Schaltungen (DFF1) mit Dateneingangsanschlüssen (DP, DN) der zweiten bis n-ten D-Flip-Flop-Schaltungen (DFF2) jeweils verbunden sind,
Eingangsanschlüsse der ersten Mehrfacheingangs-Logikgatterschaltung (NOR1) mit Ausgangsanschlüssen (QP, QN) der n-1-ten D-Flip-Flop-Schaltung (DFF2) und mit Ausgangsanschlüssen (QP, QN) der n-ten Flip-Flop-Schaltung (DFF3) verbunden sind;
Eingangsanschlüsse der zweiten Mehrfacheingangs-Logikgatterschaltung (NOR2) mit Ausgangsanschlüssen (QP, QN) der n-1-ten D-Flip-Flop-Schaltung (DFF2) verbunden sind, und das Schaltsignal (MP, MN), das differentiell ist, in die anderen Eingangsanschlüsse der zweiten Mehrfacheingangs-Logikgatterschaltung (NOR2) eingegeben wird;
ein Dateneingangsanschluss (DP, DN) der n-ten D-Flip-Flop-Schaltung (DFF3) mit einem Ausgangsanschluss der zweiten Mehrfacheingangs-Logikgatterschaltung (NOR2) verbunden ist;
sämtliche Verbindungen unter Verwendung von differentiellen Signalen sind;
jede der ersten Mehrfacheingangs-Logikgatterschaltung (NOR1) und der zweiten Mehrfacheingangs-Logikgatterschaltung (NOR2) einschließt:
erste und zweite Widerstände (R1, R2), wovon jeder ein Ende verbunden mit einer Energieversorgung (VDD) aufweist;
m erste Transistoren (M1, M2), bei welchen eine Source und ein Drain zwischen einem Ausgangsende einer Stromquelle (I-1) und dem anderen Ende des ersten Widerstands (R1) parallel verbunden sind, wobei m eine natürliche Zahl nicht geringer als zwei ist;
m zweite Transistoren (M3, M4), deren Sources und Drains zwischen dem Ausgangsende der Stromquelle (I-1) und dem anderen Ende des zweiten Widerstands (R2) in Reihe verbunden sind;
m differentielle Eingangsdaten (AP, AN/BP, BN) in jedes der Gates der ersten Transistoren (M1, M2), die parallel verbunden sind, und der Gates der zweiten Transistoren (M3, M4), die in Reihe verbunden sind, eingegeben werden; und
ein differentielles Signal (YP, YN) aus den anderen Enden jedes der ersten und zweiten Widerständen (R1, R2) ausgegeben wird.

2. Dualmodul-Vorteilerschaltung zum Teilen eines eingegebenen Taktsignals (INP, INN), um ein Teilungsverhältnis, das durch ein Schaltsignal (MP, MN) ausgewählt ist, aus einer Kombination vorbestimmter Teilungsverhältnisse zu erhalten, wobei die Dualmodul-Vorteilerschaltung umfasst:
n D-Flip-Flop-Schaltungen (DFF1-3), wobei n eine natürliche Zahl nicht geringer als drei ist;
eine erste Mehrfacheingangs-Logikgatterschaltung (NOR1), die zumindest zwei Eingänge einschließt und einen Teil der ersten D-Flip-Flop-Schaltung (DFF1) bildet;
eine zweite Mehrfacheingangs-Logikgatterschaltung (NOR2), die zumindest zwei Eingänge einschließt und einen Teil der n-ten D-Flip-Flop-Schaltung (DFF3) bildet, wobei:
interne Knoten (DP, DN) der ersten D-Flip-Flop-Schaltung (DFF1) mit Ausgangsanschlüssen der ersten Mehrfacheingangs-Logikschaltung (NOR) verbunden sind;
Ausgangsanschlüsse (QP, QN) der ersten bis n-2-ten D-Flip-Flop-Schaltungen (DFF1) mit Dateneingangsanschlüssen (DP, DN) der zweiten bis n-1-ten D-Flip-Flop-Schaltungen (DFF2) jeweils verbunden sind;
Eingangsanschlüsse der ersten Mehrfacheingangs-Logikgatterschaltung (NOR1) mit Ausgangsanschlüssen (QP, QN) der n-1-ten D-Flip-Flop-Schaltungen (DFF2) und mit Ausgangsanschlüssen (QP, QN) der n-ten Flip-Flop-Schaltung (DFF3) verbunden sind;
Eingangsanschlüsse der zweiten Mehrfacheingangs-Logikgatterschaltung (NOR2) mit Ausgangsanschlüssen (QP, QN) der n-1-ten D-Flip-Flop-Schaltung (DFF2) verbunden sind, und das Schaltsignal (MP, MN), welches differentiell ist, in die anderen Eingangsanschlüsse der zweiten Mehrfacheingangs-Logikgatterschaltung (NOR) eingegeben wird;
interne Knoten (DP, DN) der n-ten D-Flip-Flop-Schaltung (TFF3) mit Ausgangsknoten der zweiten Mehrfacheingangs-Logikgatterschaltung (NOR2) verbunden sind;
sämtliche Verbindungen unter Verwendung differentieller Signale sind;
wobei jede der ersten D-Flip-Flop-Schaltung (DFF1) und der n-ten D-Flip-Flop-Schaltung (DFF3) einschließt:
m erste Transistoren (M1A, M1B);
m zweite Transistoren (M2A, M2B);
erste und zweite Widerstände (R1, R2), die jeweils ein Ende verbunden mit einer Energieversorgung (V_{CC}) aufweisen;
dritte und vierte Transistoren (M5, M6), deren Sources mit einem Ausgangsende einer ersten Stromquelle (I-1) oder mit Masse verbunden sind;
fünfte und sechste Transistoren (M12, M13), deren Sources mit einem Drain einer zweiten Stromquelle (I-2) oder mit Masse verbunden sind;
siebte und achte Transistoren (M3, M4), deren Sources mit einem Drain des vierten Transistors (M6) verbunden sind;
neunte und zehnte Transistoren (M8, M9), deren Sources mit einem Drain des fünften Transistors (M12) verbunden sind;
elfte und zwölfte Transistoren (M10, M11), deren Sources mit einem Drain des sechsten Transistors (M13) verbunden sind;
dritte und vierte Widerstände (R3, R4), wovon jeder einen der Anschlüsse verbunden mit der Energieversorgung (VDD) aufweist, wobei:
Drains der neunten und der elften Transistoren (M8, M10) mit dem anderen Anschluss des dritten Widerstands (R3) verbunden sind;
Drains der zehnten und zwölften Transistoren (M9, M11) mit dem anderen Anschluss des vierten Widerstands (R4) verbunden sind;
die Sources und Drains der m ersten Transistoren (M1A, M1B) parallel zwischen dem dritten Transistor (M5) und dem anderen Ausgangsanschluss des ersten Widerstands (R1) angeschlossen sind;
die Sources und die Drains der m zweiten Transistoren (M2A, M2B) in Reihe zwischen dem dritten Transistor (M5) und dem anderen Ausgangsanschluss des zweiten Widerstands (R2) angeschlossen sind;
ein differentielles Taktsignal (CN, CP) in die Gates der dritten und sechsten Transistoren (M5, M13) und in die Gates der vierten und fünften Transistoren (M6, M12) eingegeben wird;
ein differentielles Signal (YN, YP) an den internen Knoten, die an den anderen Enden der ersten und zweiten Widerstände (R1, R2) gebildet sind, in die Gates der siebten und zehnten Transistoren (M3, M9) und in die Gates der achten und neunten Transistoren und in die Drains der siebten und achten Transistoren (M3, M4) eingegeben wird; und
das differentielle Ausgangssignal (QN, QP) der D-Flip-Flop-Schaltung aus den anderen Enden jedes der dritten und vierten Widerstände (R3, R4) ausgegeben wird.

3. Dualmodul-Vorteilerschaltung nach Anspruch 2, wobei die Sources der dritten, vierten, fünften und sechsten Transistoren (M5, M6, M12, M13) mit Masse verbunden sind.

## Revendications

1. Circuit prédiviseur bi-module pour diviser un signal d'horloge entré (INP, INN) afin d'obtenir un rapport de division qui est sélectionné par un signal de commutation (MP, MN) à partir d'une combinaison de rapports de division prédéterminés, le circuit prédiviseur bimodule comprenant:
n circuits bascules D (DFF1-3), n étant un entier naturel qui n'est pas inférieur à trois;
un premier circuit de porte logique à entrées multiples (NOR1) comprenant au moins deux entrées; et
un deuxième circuit de porte logique à entrées multiples (NOR2) comprenant au moins deux entrées, où:
des bornes d'entrée de données (DP, DN) du premier circuit bascule D (DFF1) sont connectées à des bornes de sortie du premier circuit logique à entrées multiples (NOR1);
des bornes de sortie (QP, QN) du premier au (n-2)^{ème} circuits bascules D (DFF1) sont connectées aux bornes d'entrée de données (DP, DN) du deuxième au (n-1)^{ème} circuits bascules D (DFF2), respectivement,
les bornes d'entrée du premier circuit de porte logique à entrées multiples (NOR1) sont connectées à des bornes de sortie (QP, QN) du (n-1)^{ème} circuit bascule D (DFF2) et aux bornes de sortie (QP, QN) du n^{ième} circuit bascule (DFF3);
les bornes d'entrée du deuxième circuit de porte logique à entrées multiples (NOR2) sont connectées aux bornes de sortie (QP, QN) du (n-1)^{ème} circuit bascule D (DFF2), et le signal de commutation (MP, MN), qui est différentiel, est entré aux autres bornes d'entrée du deuxième circuit de porte logique à entrées multiples (NOR2);
une borne d'entrée de données (DP, DN) du n^{ième} circuit bascule D (DFF3) est connectée à une borne de sortie du deuxième circuit de porte logique à entrées multiples (NOR2);
toutes les connexions sont des connexions qui utilisent des signaux différentiels;
chacun du premier circuit de porte logique à entrées multiples (NOR1) et du deuxième circuit de porte logique à entrées multiples (NOR2) comprend:
des premier et deuxième résistors (R1, R2), chacun desquels a une extrémité connectée à une alimentation électrique (VDD);
m premiers transistors (M1, M2) dans lesquels une source et un drain sont connectés entre une extrémité de sortie d'une source de courant (I-1) et l'autre extrémité du premier résistor (R1) en parallèle, m étant un entier naturel qui n'est pas inférieur à deux;
m deuxièmes transistors (M3, M4) dont les sources et les drains sont connectés entre l'extrémité de sortie de la source de courant (I-1) et l'autre extrémité du deuxième résistor (R2) en série;
m données d'entrées différentielles (AP, AN/BP, BN) sont entrées à chacune des portes des premiers transistors (M1, M2) connectés en parallèle et des portes des deuxièmes transistors (M3, M4) connectés en série; et
un signal différentiel (YP, YN) est sorti depuis les autres extrémités du chacun des premier et deuxième résistors (R1, R2).

2. Circuit prédiviseur bi-module pour diviser un signal d'horloge entré (INP, INN) afin d'obtenir un rapport de division qui est sélectionné par un signal de commutation (MP, MN) à partir d'une combinaison de rapports de division prédéterminés, le circuit prédiviseur bi-module comprenant:
n circuits bascules D (DFF1-3), n étant un entier naturel qui n'est pas inférieur à trois;
un premier circuit de porte logique à entrées multiples (NOR1) comprenant au moins deux entrées et formant une partie du premier circuit bascule D (DFF1);
un deuxième circuit de porte logique à entrées multiples (NOR2) comprenant au moins deux entrées et formant une partie du n^{ième} circuit bascule D (DFF3), dans lequel;
des noeuds internes (DP, DN) du premier circuit bascule D (DFF1) sont connectés aux bornes de sortie du premier circuit logique à entrées multiples (NOR1);
les bornes de sortie (QP, QN) du premier au (n-2)^{ème} circuits bascules D (DFF1) sont connectées aux bornes d'entrée de données (DP, DN) du deuxième au (n-1)^{ème} circuits bascules D (DFF2), respectivement,
les bornes d'entrée du premier circuit de porte logique à entrées multiples (NOR1) sont connectées aux bornes de sortie (QP, QN) du (n-1)^{ème} circuit bascule D (DFF2) et aux bornes de sortie (QP, QN) du n^{ième} circuit bascule (DFF3);
les bornes d'entrée du deuxième circuit de porte logique à entrées multiples (NOR2) sont connectées aux bornes de sortie (QP, QN) du (n-1)^{ème} circuit bascule D (DFF2), et le signal de commutation (MP, MN), qui est différentiel, est entré aux autres bornes d'entrée du deuxième circuit de porte logique à entrées multiples (NOR2);
les noeuds internes (DP, DN) du n^{ième} circuit bascule D (DFF3) sont connectés aux noeuds de sortie du deuxième circuit de porte logique à entrées multiples (NOR2);
toutes les connexions sont des connexions qui utilisent des signaux différentiels;
où chacun du premier circuit bascule D (DFF1) et du n^{ième} circuit bascule D (DFF3) comprend:
m premiers transistors (M1A, M1B);
m deuxièmes transistors (M2A, M2B);
les premier et deuxième résistors (R1, R2), ayant chacun une extrémité connectée à une alimentation électrique (Vcc);
les troisième et quatrième transistors (M5, M6) dont les sources sont connectées à une extrémité de sortie d'une première source de courant (I-1), ou au sol;
les cinquième et sixième transistors (M12, M13) dont les sources sont connectées à un drain d'une deuxième source de courant (1-2), ou au sol;
les septième et huitième transistors (M3, M4) dont les sources sont connectées à un drain du quatrième transistor (M6);
les neuvième et dixième transistors (M8, M9) dont les sources sont connectées à un drain du cinquième transistor (M12);
les onzième et douzième transistors (M10, M11) dont les sources sont connectées à un drain du sixième transistor (M13);
les troisième et quatrième résistors (R3, R4) chacun desquels a l'une des bornes connectée à l'alimentation électrique (VDD), où:
les drains des neuvième et onzième transistors (M8, M10) sont connectés à l'autre borne du troisième résistor (R3);
les drains du dixième et du douzième transistors (M9, M11) sont connectés à l'autre borne du quatrième résistor (R4);
les sources et les drains des m premiers transistors (M1A, M1B) sont accouplés en parallèle entre le troisième transistor (M5) et l'autre borne de sortie du premier résistor (R1);
les sources et les drains des m deuxièmes transistors (M2A, M2B) sont accouplés en série entre le troisième transistor (M5) et l'autre borne de sortie du deuxième résistor (R2);
un signal d'horloge différentiel (CN, CP) est entré aux portes des troisième et sixième transistors (M5, M13) et aux portes des quatrième et cinquième transistors (M6, M12);
un signal différentiel (YN, YP) auxdits noeuds internes, formé aux autres extrémités des premier et deuxième résistors (R1, R2) est entré aux portes des septième et dixième transistors (M3; M9) et aux portes des huitième et neuvième transistors (M4, M8), et aux drains des septième et huitième transistors (M3, M4); et
le signal de sortie différentiel (QN, QP) du circuit bascule D est sorti depuis les autres extrémités de chacun des troisième et quatrième résistors (R3, R4).

3. Circuit prédiviseur bi-module selon la revendication 2, dans lequel
les sources des troisième, quatrième, cinquième et sixième transistors (M5, M6, M12, M13) sont mises à la terre.
